# EUROPEAN PATENT APPLICATION

(11) **EP 4 738 425 A1**
(43) Date of publication of application: **06.05.2026**
(21) Application number: 24831579.8
(22) Date of filing: 04.06.2024
(51) Int. Cl.: H01L 21/02, G05B 23/02, G06Q 50/04

(54) **WORK ASSISTANCE METHOD AND WORK ASSISTANCE SYSTEM**

(30) Priority: 27.06.2023 JP 2023104670
(71) Applicant: SCREEN Holdings Co., Ltd., Kyoto-shi, Kyoto 602-8585 (JP)
(72) Inventor: SHIMIZU Shinji, Kyoto-shi, Kyoto 602-8585 (JP)
(74) Representative: Kilian Kilian & Partner mbB
(86) International application number: PCT/JP2024/020306
(87) International publication number: WO 2025/004709

(57) **Abstract**

Information on an apparatus condition of a substrate processing apparatus is collected, and a determination as to whether a target region in the substrate processing apparatus is dangerous is made based on the condition information. Smart glasses display a color in a manner superimposed over a space including the target region determined to be dangerous. The smart glasses display a color on the space including the target region, using a display color corresponding to the danger level to which the target region corresponds. When the danger level drops, as a result of a measure taken by a worker, the display color is updated. Because the smart glasses visualize the danger not directly perceivable with human eyes by coloring, the worker can reliably recognize an invisible dangerous condition.

## Description

### TECHNICAL FIELD

The present invention relates to a work assistance method and a work assistance system at the time when predetermined work, such as maintenance, is performed on industrial equipment such as a substrate processing apparatus that performs a predetermined process on a substrate. Examples of a substrate to be processed by the substrate processing apparatus include a semiconductor substrate, a substrate for a liquid crystal display, a substrate for a flat panel display (FPD), a substrate for an optical disc, a substrate for a magnetic disk, or a substrate for a solar cell.

### BACKGROUND ART

Conventionally, in a manufacturing process of a semiconductor device, a substrate processing apparatus that performs various types of processing on a substrate such as a semiconductor substrate is used. As a substrate processing apparatus, for example, a substrate cleaning apparatus, a thermal treatment apparatus, and an inspection apparatus are used. Typically, the substrate processing apparatuses are often arranged in a large number, in an orderly manner, in a wide clean room. Maintenance is performed on these substrate processing apparatuses at an appropriate timing. Patent Document 1 describes arranging a large number of substrate processing apparatuses at a relatively high density in a clean room, and performing maintenance of the substrate processing apparatuses.

### PRIOR ART DOCUMENT

### PATENT DOCUMENT

Patent Document 1: Japanese Patent Application Laid-Open No. 2020-4866

### SUMMARY

### PROBLEM TO BE SOLVED BY THE INVENTION

At the time of carrying out maintenance on the substrate processing apparatus, a worker may open the cover of a chamber, or work on a pipe. However, the inside of the chamber may be in a dangerous condition. For example, when the inside of the chamber is purged with nitrogen gas, the inside of the chamber is in a dangerous condition, with almost no oxygen. Furthermore, immediately after the use of a chemical liquid such as hydrofluoric acid, the chamber may be filled with vapor of the chemical liquid, or the chemical liquid may be attached as droplets. Moreover, inside a pipe connected to the chamber, there may be a high residual pressure.

Because these dangerous conditions are invisible to human eyes, it is impossible for workers to directly confirm these dangers, visually. If the worker carries out the maintenance work without recognizing the dangerous condition, an accident may occur.

The present invention has been made in view of the problem described above, and an object of the present invention is to provide a work assistance method and a work assistance system that enable a worker to recognize invisible dangerous conditions, reliably.

### MEANS TO SOLVE THE PROBLEM

In order to solve the problem described above, a first aspect of the present invention provides a work assistance method for predetermined work to be carried out on industrial equipment, the work assistance method including: an information acquisition step of collecting condition information related to an apparatus condition of the industrial equipment; a determination step of determining whether a target region of the industrial equipment is dangerous based on the condition information; and a display step of causing a mobile terminal including a display unit and a communication unit to display an annotation on the target region determined to be dangerous in the determination step.

According to a second aspect, in the work assistance method according to the first aspect, in the display step, the mobile terminal is caused to display a color in a manner superimposed over a space including the target region.

According to a third aspect, in the work assistance method according to the second aspect, the determination step includes determining which of a plurality of danger levels the target region corresponds to, and the display step includes displaying a display color corresponding to a danger level to which the target region corresponds, on the space including the target region.

According to a fourth aspect, in the work assistance method according to the third aspect, when the danger level of the target region changes, as a result of an operation performed on the target region, the display color is changed in accordance with a danger level after change.

According to a fifth aspect, in the work assistance method according to the first aspect, the work assistance method further includes a registration step of registering a pertinent region with a chance of occurrence of a danger, in association with each type of work to be performed on the industrial equipment, in which, the determination step includes determining, when a work type is input from the mobile terminal, whether the pertinent region registered in association with the work type is dangerous, and the display step includes displaying an annotation on the pertinent region determined to be dangerous.

According to a sixth aspect, in the work assistance method according to the fifth aspect, the display step includes displaying a first display color on the space including the pertinent region determined to be dangerous, and displaying a second display color on the space including the pertinent region determined not to be dangerous.

According to a seventh aspect, in the work assistance method according to the sixth aspect, when the pertinent region determined to be dangerous becomes no longer dangerous, as a result of an operation performed on the pertinent region, the color displayed on the space including the pertinent region is changed from the first display color to the second display color.

According to an eighth aspect, in the work assistance method according to any one of the first to seventh aspects, the industrial equipment is a substrate processing apparatus that performs a predetermined process on a substrate.

According to a ninth aspect, in the work assistance method according to the eighth aspect, the substrate processing apparatus is a substrate cleaning apparatus that uses a treatment gas and a treatment liquid.

According to a tenth aspect, in the work assistance method according to any one of the first to ninth aspects, the mobile terminal is a pair of smart glasses.

An eleventh aspect provides a work assistance system for predetermined work to be carried out on industrial equipment, the work assistance system including: a mobile terminal including a display unit and a communication unit; and a determination unit that determines whether a target region in the industrial equipment is dangerous based on condition information related to an apparatus condition of the industrial equipment, in which the display unit displays an annotation on the target region determined to be dangerous by the determination unit.

According to a twelfth aspect, in the work assistance system according to the eleventh aspect, the display unit displays a color in a manner superimposed over a space including the target region.

According to a thirteenth aspect, in the work assistance system according to the twelfth aspect, the determination unit determines which of a plurality of danger levels the target region corresponds to, and the display unit displays a display color corresponding to the danger level to which the target region corresponds, on the space including the target region.

According to a fourteenth aspect, in the work assistance system according to the thirteenth aspect, when the danger level of the target region changes as a result of an operation performed on the target region, the display unit changes the display color in accordance with the danger level after change.

According to a fifteenth aspect, in the work assistance system according to the eleventh aspect, the work assistance system further includes a storage unit that stores a table in which a pertinent region with a chance of occurrence of a danger is registered, in association with each type of work on the industrial equipment, in which, when a work type is input from the mobile terminal, the determination unit determines whether the pertinent region registered in association with the work type is dangerous, and the display unit displays an annotation on the pertinent region determined to be dangerous.

According to a sixteenth aspect, in the work assistance system according to the fifteenth aspect, the display unit displays a first display color on a space including the pertinent region determined to be dangerous, and displays a second display color on a space including the pertinent region determined not to be dangerous.

According to a seventeenth aspect, in the work assistance system according to the sixteenth aspect, when the pertinent region becomes no longer dangerous as a result of an operation performed on the pertinent region determined to be dangerous, the display unit changes the color of the space including the pertinent region from the first display color to the second display color.

According to an eighteenth aspect, in the work assistance system according to any one of the eleventh to seventeenth aspects, the industrial equipment is a substrate processing apparatus that performs a predetermined process on a substrate.

According to a nineteenth aspect, in the work assistance system according to the eighteenth aspect, the substrate processing apparatus is a substrate cleaning apparatus that uses a treatment gas and a treatment liquid.

According to a twentieth aspect, in the work assistance system according to any one of the eleventh to nineteenth aspects, the mobile terminal is a pair of smart glasses.

### EFFECTS OF THE INVENTION

With the work assistance method according to the first to tenth aspects, a determination as to whether the target region in the industrial equipment is dangerous is made based on the collected condition information, and the mobile terminal displays an annotation on the target region determined to be dangerous. Therefore, the dangerous condition that is not directly perceivable by human eyes is visualized and displayed, so that the worker can recognize such an invisible dangerous condition, reliably.

In particular, with the work assistance method according to the third aspect, because a display color corresponding to the danger level to which the target region corresponds is displayed on the space including the target region, the worker can easily recognize the danger level of the target region.

With the work assistance system according to the eleventh to twentieth aspects, a determination as to whether the target region in the industrial equipment is dangerous is made based on condition information related to an apparatus condition of the industrial equipment, and the mobile terminal displays an annotation on the target region determined to be dangerous. Therefore, the dangerous condition that is not directly perceivable by human eyes is visualized and displayed, so that the worker can recognize such an invisible dangerous condition, reliably.

In particular, with the work assistance system according to the thirteenth aspect, because a display color corresponding to the danger level to which the target region corresponds is displayed on the space including the target region, the worker can easily recognize the danger level of the target region.

### BRIEF DESCRIPTION OF DRAWINGS

[FIG. 1] is a diagram schematically illustrating a general configuration of a work assistance system according to the present invention.
[FIG. 2] is a plan view illustrating an example of a layout of a plurality of substrate processing apparatuses.
[FIG. 3] is a diagram illustrating a configuration of one substrate processing apparatus.
[FIG. 4] is a diagram illustrating a general configuration of a processing unit.
[FIG. 5] is a perspective view illustrating the appearance of smart glasses.
[FIG. 6] is a block diagram illustrating a functional configuration of the smart glasses, a server, a work assistance terminal, and a control unit of a substrate processing apparatus.
[FIG. 7] is a flowchart illustrating the sequence of a work assistance method according to the first embodiment.
[FIG. 8] is a diagram illustrating an example of a spatial mesh.
[FIG. 9] is a diagram schematically illustrating a relative positional relationship between a reference position and a region in the substrate processing apparatus.
[FIG. 10] is a diagram illustrating an example of a danger table.
[FIG. 11] is a diagram illustrating an example of display of an annotation.
[FIG. 12] is a flowchart illustrating the sequence of a work assistance method according to a second embodiment.
[FIG. 13] is a diagram illustrating an example of a work table registered with a pertinent region with a chance of occurrence of a danger, in a manner associated with each type of work.

### DESCRIPTION OF EMBODIMENTS

Embodiments of the present invention will now be described in detail with reference to drawings. In the description hereunder, unless otherwise specified, an expression indicating a relative or absolute positional relationship (such as "in one direction," "along one direction," "parallel," "orthogonal," "central," "concentric," or "coaxial") is not only indication of the positional relationship in a strict sense, but also indicates a state displaced in terms of an angle or a distance within a range within a tolerance, or a range in which equivalent functions can be achieved. In addition, unless specified otherwise, an expression indicating the state of being the same (such as "identical," "equal," or "homogeneous") not only represents a state of being the same strictly quantitatively, but also represents a state exhibiting a difference within a tolerance, or within a range in which equivalent functions can be achieved. Furthermore, unless specified otherwise, an expression indicating a shape (such as "a circular shape", "a quadrangular shape", or "a cylindrical shape") not only represents the shape strictly geometrically, but also represents a shape within a range where the same level of effect can be achieved, and may have some irregularities or chamfering, for example. In addition, expressions such as "being provided with", "being equipped with", "comprising", "including", and "having" a component are not exclusive expressions excluding the presence of other components. In addition, the expression "at least one of A, B, and C" includes "only A", "only B", "only C", "any two of A, B, and C", and "all of A, B and C".

### <First Embodiment>

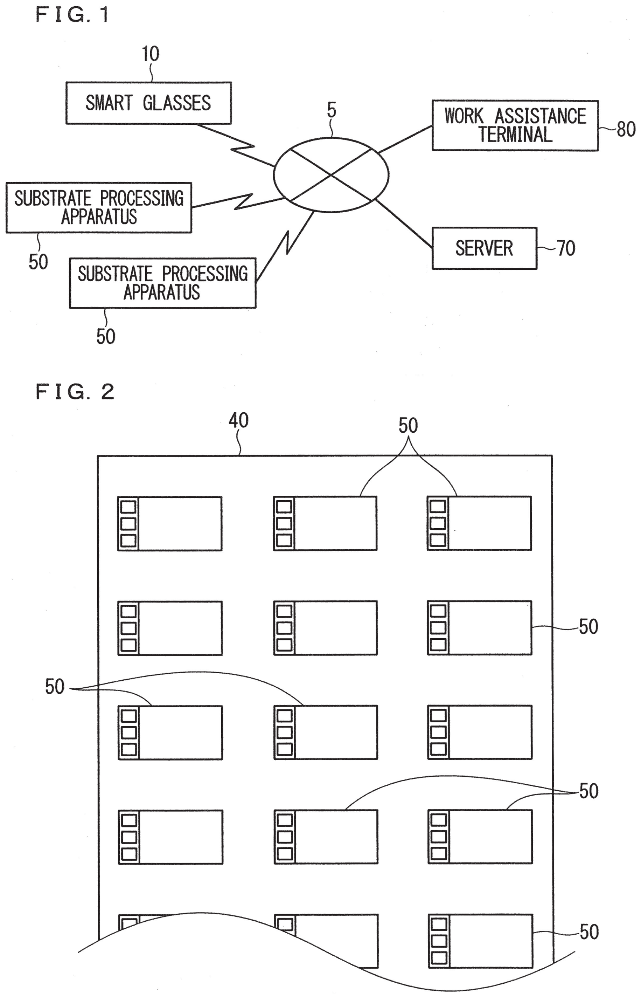

FIG. 1 is a diagram schematically illustrating a general configuration of a work assistance system according to the present invention. The work assistance system according to the present invention includes a plurality of substrate processing apparatuses 50, smart glasses 10, a server 70, and a work assistance terminal 80. The smart glasses 10 and the controller of the substrate processing apparatuses 50 are connected to an information communication network 5 (e.g., the Internet) via wireless communication. The work assistance terminal 80 and the server 70 are connected to the information communication network 5 over the wire. Pieces of equipment connected to the information communication network 5 can exchange information. For example, the smart glasses 10 and the work assistance terminal 80 can exchange information. The wireless or wired connection between each piece of the equipment and the information communication network 5 is not limited to the examples described above, and an appropriate mode may be used (for example, the work assistance terminal 80 and the information communication network 5 may be connected wirelessly).

FIG. 2 is a plan view illustrating an example of a layout of the plurality of substrate processing apparatuses 50. As illustrated in FIG. 2, the plurality of substrate processing apparatuses 50 are arranged in an orderly manner, at regular intervals in a clean room 40. The clean room 40 is, for example, a room provided in a semiconductor device manufacturing factory, and is a room in which a certain degree of cleanness of the air is ensured, with the temperature and the humidity controlled. In the first embodiment, a plurality of the same type of substrate processing apparatuses 50 are disposed in a relatively wide clean room 40. Therefore, it is difficult for a worker to distinguish one substrate processing apparatus 50 from the others that are disposed in the clean room 40, only based on its appearance.

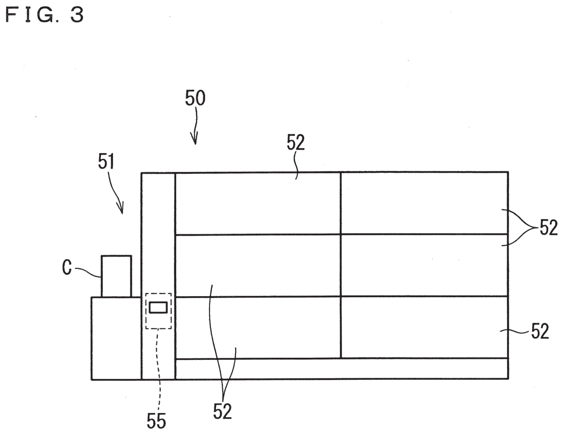

FIG. 3 is a diagram illustrating a configuration of one of such substrate processing apparatuses 50. In the first embodiment, the substrate processing apparatus 50 is, for example, a single-wafer substrate cleaning apparatus that cleans one substrate at a time. The substrate processing apparatus 50 includes an indexer 51 and a plurality of processing units 52. On the indexer 51, a carrier C holding a plurality of substrates is placed. The indexer 51 takes out an unprocessed substrate from the carrier C placed thereon, using an indexer robot, not illustrated. The indexer 51 also stores a processed substrate in the carrier C, using the indexer robot. The carrier C is, for example, a front opening unified pod (FOUP) that houses a substrate in a sealed space.

In the first embodiment, three processing units 52, for example, are stacked to form one stack. For example, four stacks are disposed around a main transport robot, not illustrated. In other words, one substrate processing apparatus 50 includes twelve (=3×4) processing units 52, for example.

The main transport robot disposed at the center of the four stacks transports an unprocessed substrate received from the indexer robot into any one of the twelve processing units 52. The main transport robot also takes out a processed substrate from the processing unit 52, and passes the substrate to the indexer robot.

The substrate processing apparatus 50 further includes a control unit 55. The control unit 55 is a general computer, and controls operations of the indexer robot, the main transport robot, and each of the processing units 52 that are provided to the apparatus. The control unit 55 includes a touch panel that is an input/output interface provided on a wall surface of the apparatus, and a communication unit that communicates with outside of the apparatus.

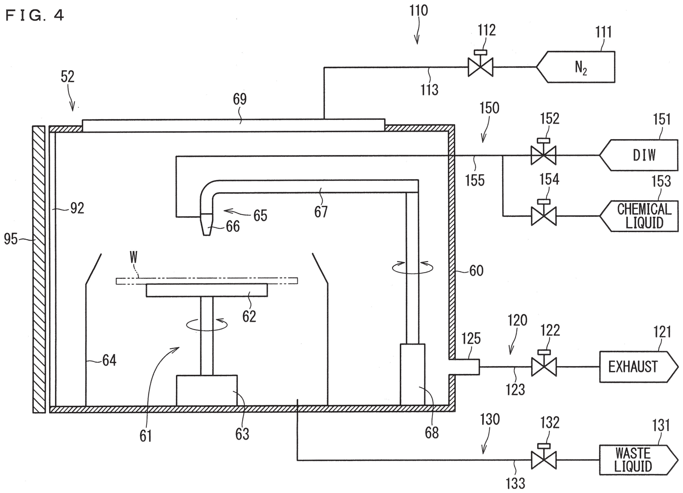

FIG. 4 is a diagram illustrating a general configuration of one of the processing units 52. The processing unit 52 performs cleaning processing by discharging treatment liquid to one substrate W. The treatment liquid is a term representing a concept covering various chemical liquids and pure water. Examples of the chemical liquid include a liquid for applying etching treatment, and a liquid for removing particles, and, specifically, SC-1 solution (mixed solution of ammonium hydroxide, hydrogen peroxide water, and pure water), SC-2 solution (mixed solution of hydrochloric acid, hydrogen peroxide water, and pure water), hydrofluoric acid, or the like is used.

The processing unit 52 includes a treatment chamber 60, a rotation holder 61, and a treatment liquid nozzle 65. The treatment chamber 60 is a hollow housing. The rotation holder 61, the treatment liquid nozzle 65, and the like are provided inside the treatment chamber 60. The treatment chamber 60 is provided with an access port, not illustrated. The access port is opened and closed by a shutter. While the access port is open, the main transport robot transports a substrate W into and out of the treatment chamber 60. The access port is kept closed during the treatment of the substrate W.

The rotation holder 61 includes a spin chuck 62 and a spin motor 63. The spin chuck 62 is a substrate holder that holds a substrate W in a horizontal orientation (the orientation in which the normal line of the main surface of the substrate W extends in the vertical direction). The spin chuck 62 is, for example, a vacuum chuck. The spin chuck 62 has a disk-like shape having a diameter smaller than the diameter of the substrate W. The spin chuck 62 suctions to hold the central part of the bottom surface of the substrate W. While the bottom surface of the substrate W is being suctioned and held by the spin chuck 62, a peripheral edge of the substrate W is projecting outward from the outer periphery of the spin chuck 62. The spin chuck 62 may be a chuck of another type, such as a mechanical clamp chuck.

The spin chuck 62 is connected to the spin motor 63 via a motor shaft. In other words, the upper end of the motor shaft of the spin motor 63 is connected to the central part of the bottom surface of the spin chuck 62. When the spin motor 63 rotates the motor shaft in a state in which the substrate W is being suctioned and held by the spin chuck 62, the substrate W and the spin chuck 62 rotate on a horizontal plane around a rotation axis that extends along the vertical direction.

A cup 64 is provided in a manner surrounding the periphery of the spin chuck 62. The cup 64 can be moved up and down by a lifting mechanism, not illustrated. The cup 64 has a cylindrical shape, and an upper part of the cup 64 is inclined in a manner approaching the spin chuck 62, as the cup 64 extends further upward. The upper end of the cup 64, however, has an inner diameter larger than the diameter of the substrate W. During the treatment of the substrate W, the upper end of the cup 64 is at a position higher than the height position of the substrate W being held by the spin chuck 62. Therefore, the liquid scattered from the substrate W being rotated by the spin motor 63, due to the centrifugal force, is received and recovered by the cup 64. The cup 64 may have a multistage structure provided with a plurality of collection ports each provided for one use.

The treatment liquid nozzle 65 includes a nozzle tip 66, a swing arm 67, and a swing motor 68. The treatment liquid nozzle 65 is, for example, a straight nozzle that discharges the treatment liquid as a continuous flow. The nozzle tip 66 is attached to the tip of the swing arm 67 extending in a substantially horizontal direction. The bottom end of the nozzle tip 66 is provided with a discharge port, not illustrated, and the treatment liquid is discharged from the discharge port. The swing arm 67 is swung across a horizontal plane, about an axis extending along the vertical direction, by the swing motor 68. The swing motor 68 is, for example, a pulse motor.

When the swing motor 68 swings the swing arm 67, the nozzle tip 66 moves along an arc path, between a treatment position above the substrate W held by the rotation holder 61 and a standby position outside the cup 64. When the nozzle tip 66 is at the treatment position, the treatment liquid nozzle 65 discharges the chemical liquid onto the substrate W held by the rotation holder 61, so that cleaning treatment of the substrate W takes place, for example. Further, as the treatment liquid nozzle 65 discharges pure water onto the substrate W, pure-water rinsing treatment of the substrate W takes place. An encoder for detecting the position of the nozzle tip 66 may be attached to the swing motor 68.

The processing unit 52 includes a gas feeder unit 110, an exhaust unit 120, a drainage unit 130, and a treatment liquid feeder unit 150. The gas feeder unit 110 supplies a treatment gas into the treatment chamber 60. The gas feeder unit 110 includes a nitrogen supply source 111, an intake valve 112, and a pipe 113. The tip-end side of the pipe 113 is connected to a fan filter unit (FFU) 69 provided to the ceiling of the treatment chamber 60, and the base-end side is connected to the nitrogen supply source 111. The FFU 69 includes a fan that generates an gas flow, and a filter (e.g., HEPA filter or ULPA filter) that collects and removes particles contained in the gasflow. The intake valve 112 is provided to an intermediate part of the route of the pipe 113. When the intake valve 112 is opened, nitrogen gas (N₂) is supplied from the nitrogen supply source 111 through the pipe 113 to the FFU 69, and nitrogen gas is supplied from the FFU 69 into the treatment chamber 60. The FFU 69 generates a downflow of the gas into the treatment chamber 60 from top to bottom.

The exhaust unit 120 discharges the atmosphere inside of the treatment chamber 60. The exhaust unit 120 includes an exhaust apparatus 121, an exhaust valve 122, and a pipe 123. The tip-end side of the pipe 123 is connected to an exhaust duct 125 provided in the treatment chamber 60, and the base-end side is connected to the exhaust apparatus 121. The exhaust apparatus 121 includes, for example, a vacuum pump. The exhaust valve 122 is provided to an intermediate part of the route of the pipe 123. When the exhaust valve 122 is opened while the exhaust apparatus 121 is in operation, the gas in the treatment chamber 60 is exhausted through the exhaust duct 125.

The drainage unit 130 drains used liquid collected by the cup 64, to the outside of the treatment chamber 60. The drainage unit 130 includes a waste liquid treatment apparatus 131, a drainage valve 132, and a pipe 133. The tip-end side of the pipe 133 is connected to the bottom of the cup 64, and the base-end side is connected to the waste liquid treatment apparatus 131. The drainage valve 132 is provided to an intermediate part of the route of the pipe 133. When the drainage valve 132 is opened, the liquid collected by the cup 64 flows through the pipe 133, and is discharged to the waste liquid treatment apparatus 131.

The treatment liquid feeder unit 150 feeds the treatment liquid into the treatment liquid nozzle 65. The treatment liquid feeder unit 150 includes a pure water supply source 151, a pure water valve 152, a chemical liquid supply source 153, a chemical liquid valve 154, and a pipe 155. The tip-end side of the pipe 155 is connected to the nozzle tip 66 of the treatment liquid nozzle 65, and the base-end side splits into two branches, one of which is connected to the pure water supply source 151 and the other is connected to the chemical liquid supply source 153. Of the two branch pipes extending from the pipe 155, the pure water valve 152 is provided to the one connected to the pure water supply source 151, and the chemical liquid valve 154 is provided to the other connected to the chemical liquid supply source 153. When the pure water valve 152 is opened, pure water is discharged from the treatment liquid nozzle 65. When the chemical liquid valve 154 is opened, the chemical liquid is discharged from the treatment liquid nozzle 65. Further, it is possible to cause the treatment liquid nozzle 65 to discharge the chemical liquid diluted with pure water by opening both of the chemical liquid valve 154 and the pure water valve 152.

The treatment chamber 60 in the processing unit 52 is provided with an inner cover 92 and an outer cover 95. The inner cover 92 is a transparent plate-like member, such as an acrylic plate. The inner cover 92 is provided in a manner facing the inner space of the treatment chamber 60. By contrast, the outer cover 95 is an opaque plate-like member made of metal, for example. The outer cover 95 is provided outside of the inner cover 92, in a manner covering the inner cover 92.

Both of the inner cover 92 and the outer cover 95 are provided in a manner enabled to be opened and closed. When the inner cover 92 and the outer cover 95 are both closed, a worker cannot visually recognize the inside of the treatment chamber 60. When the outer cover 95 is opened and only the inner cover 92 is closed, the worker can visually recognize the inside of the treatment chamber 60 through the transparent inner cover 92. When the outer cover 95 and the inner cover 92 are both open, the inside of the treatment chamber 60 is exposed, and the worker can work on the spin chuck 62 and the treatment liquid nozzle 65 that are inside the treatment chamber 60.

The worker who carries out work such as maintenance and inspection on the plurality of substrate processing apparatuses 50 that are arranged in the clean room 40 wears the smart glasses 10. The pair of smart glasses 10 is one type of wearable head-mounted display (HMD) terminal. The pair of smart glasses 10 also is an apparatus for implementing the augmented reality (AR) or mixed reality (MR). As the smart glasses 10, for example, "HoloLens" (registered trademark) manufactured by Microsoft Corporation may be used.

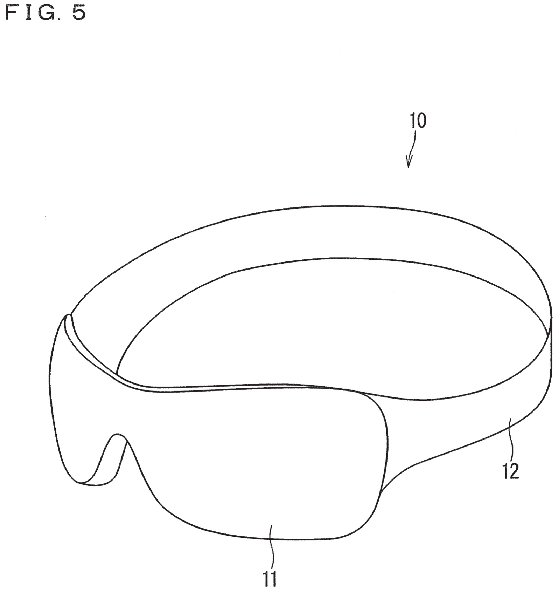

FIG. 5 is a perspective view illustrating the appearance of the smart glasses 10. The smart glasses 10 include a visor 11 and a headband 12. The worker wears the smart glasses 10 by wearing the headband 12 on his/her head. The worker can adjust the length of the headband 12 in accordance with the size of his/her head. The headband 12 is also provided with a power button, a brightness button, a volume button, and the like.

The visor 11 includes various sensors and a display. The display is a see-through holographic lens. In other words, the display can display a stereoscopic image within the space in the field of view of the worker, as a hologram, and transmits the light from objects in the real space, in the same manner as an ordinary spectacle lens. Therefore, the worker wearing the smart glasses 10 can perceive a stereoscopic image being displayed, while visually recognizing the real objects through the display.

Examples of the sensors provided to the visor 11 include a plurality of visible light cameras that mainly capture an image on the front side of the visor 11, an infrared camera that keeps track of the line of sight of the worker, a depth sensor that measures the distance to an object, an inertial measurement sensor, and the like. The infrared camera measures the movement of the eyeballs of the wearer of the smart glasses 10 to keep track of the line of sight. The depth sensor measures the distance to an object using the time-of-flight (ToF) technique, for example. The inertial measurement sensor includes an accelerometer, a gyroscope, and a magnetometer.

In the smart glasses 10, a computer including a CPU and a memory or the like is incorporated. The smart glasses 10 are also provided with a wireless communication mechanism, and the computer on the smart glasses 10 is connected to the information communication network 5 using the wireless communication mechanism. The smart glasses 10 are also provided with a microphone, a speaker, a battery, and the like.

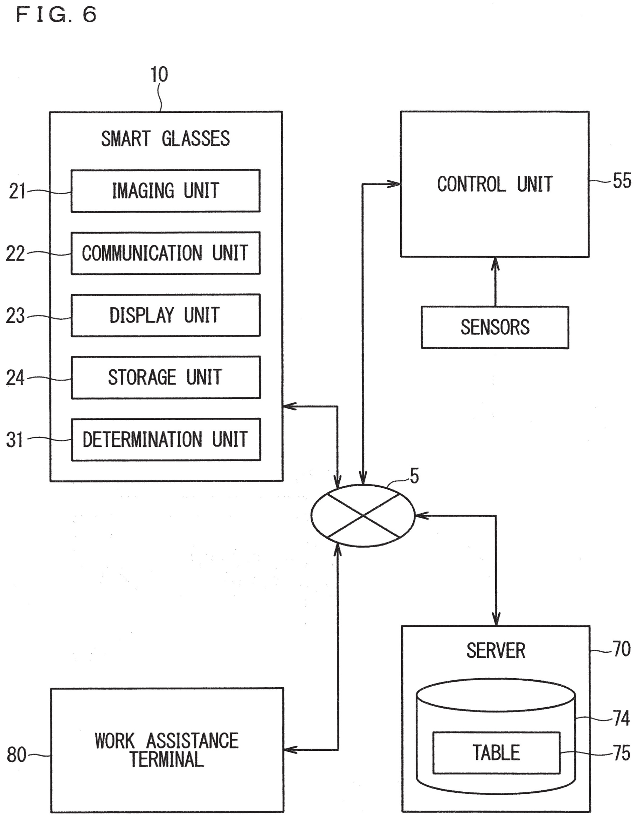

FIG. 6 is a block diagram illustrating functional configurations of the smart glasses 10, the server 70, the work assistance terminal 80, and the control unit 55 of the substrate processing apparatus 50. The smart glasses 10 include an imaging unit 21, a communication unit 22, a display unit 23, and a storage unit 24. The imaging unit 21 includes a visible-light camera provided to the visor 11 described above. The imaging unit 21 includes, for example, four visible light cameras that capture the images of the front side and diagonally front sides, and are capable of capturing an image within the range of the field of view of the worker wearing the smart glasses 10.

The communication unit 22 includes the wireless communication mechanism of the smart glasses 10 described above. The communication unit 22 transmits and receives data to and from the work assistance terminal 80 and the server 70 via the information communication network 5. The communication unit 22 can also transmit and receive data directly to and from the control unit 55 in the substrate processing apparatus 50, if the distance therebetween is short. In other words, the communication unit 22 can transmit data and commands to the control unit 55 in the substrate processing apparatus 50 directly, or over the information communication network 5.

The display unit 23 includes the display of the visor 11 described above. The display unit 23 includes a holographic processing apparatus, and displays a stereoscopic image at a predetermined spatial position, using a hologram technology. Note that the stereoscopic image displayed by the display unit 23 is not limited to those having a three-dimensional shape, and may be a two-dimensional image such as a document.

The storage unit 24 includes a memory and a storage that are mounted on the smart glasses 10. The memory and the storage included in the smart glasses 10 are, for example, a dynamic random-access memory (DRAM) and a universal flash storage (UFS), respectively. The storage unit 24 stores therein applications and data used by the computer in the smart glasses 10.

The smart glasses 10 also include a determination unit 31. The determination unit 31 is a functional processing unit implemented by causing the CPU in the smart glasses 10 to execute a predetermined processing program. The processing of the determination unit 31 will be further described later.

The control unit 55 in the substrate processing apparatus 50 controls the operation of various mechanisms, such as the treatment liquid nozzles 65, provided to the processing units 52. The control unit 55 in the substrate processing apparatus 50 can communicate with the communication unit 22 of the smart glasses 10, and can also control the operation of various mechanisms provided to the processing units 52 in accordance with a command operation instruction transmitted from the smart glasses 10.

To the control unit 55, detection signals from a large number of sensors in the substrate processing apparatus 50 are transmitted. The sensors provided to the substrate processing apparatus 50 include, for example, a chemical liquid densitometer and a sensor that detects opening and closing of each of the valves.

The work assistance terminal 80 and the server 70 are installed, for example, in a factory of a vendor that manufactures and inspects the substrate processing apparatus 50. The work assistance terminal 80 and the server 70 can communicate with the smart glasses 10 via the information communication network 5. The work assistance terminal 80 and the server 70 can communicate with each other via the information communication network 5.

The work assistance terminal 80 and the server 70 are general computer systems. In other words, each of the work assistance terminal 80 and the server 70 includes a CPU that is a circuit that performs various arithmetic processing, a ROM that is a read-only memory that stores therein a basic program, a RAM that is a readable/writable memory that stores therein various types of information, a storage unit (such as a magnetic disk or SSD) that stores therein control software, data, and the like, and a communication unit that communicates with the information communication network 5.

The work assistance terminal 80 is, for example, a computer for allowing work assisting staff from the vendor to support the work of the worker in the clean room 40. The work assisting staff can transmit various types of information from the work assistance terminal 80 to the smart glasses 10 worn by the worker in the clean room 40.

In the work assistance system according to the present invention, the server 70 is a computer that executes a predetermined process in response to requests from the smart glasses 10 and the work assistance terminal 80. The server 70 includes a storage unit 74 having a relatively large capacity. Large-size data created by the smart glasses 10 and the work assistance terminal 80 may be stored in the storage unit 74. Note that the server 70 is not an essential element.

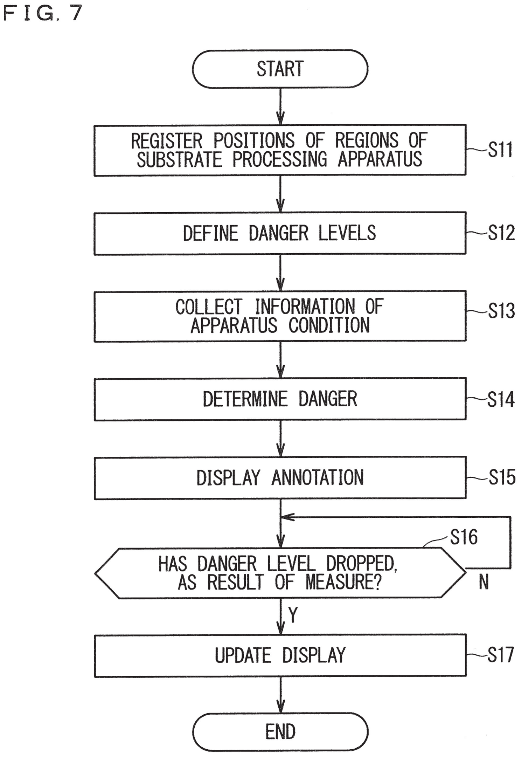

A work assistance method using the work assistance system with the configuration described above will now be explained. FIG. 7 is a flowchart illustrating the sequence of the work assistance method according to the first embodiment. Of the steps illustrated in FIG. 7, steps S11 and S12 are steps of preliminary preparations.

To begin with, the positions of the regions included in the substrate processing apparatus 50 are registered (step S11). This step is performed using a visual positioning system (VPS) function of the smart glasses 10.

In the description hereunder, the worker may perform an operation such as selecting or making an input on a stereoscopic image displayed by the display unit 23 of the smart glasses 10. This means that, when the worker performs an operation such as selecting or making an input on a stereoscopic image displayed by the display unit 23, using a hand gesture, the imaging unit 21 captures an image of the hand gesture and detects the hand gesture, and the computer in the smart glasses 10 recognizes that a predetermined operation has been made, based on the detection result. Alternatively, when the worker performs an operation such as selecting or making an input on a stereoscopic image displayed by the display unit 23, using a movement of the line of sight, the smart glasses 10 may keep track of the line of sight and detect the line of sight using the eye tracking function, and recognize that a predetermined operation has been made.

As steps of preliminary preparations, a part of the inside of the clean room 40 is scanned using the smart glasses 10 to create a spatial mesh. This processing is performed by, for example, a worker wearing the smart glasses 10 in the clean room 40, using the smart glasses 10.

The worker turns on a preset scan mode of the smart glasses 10. For example, the worker can select a scan mode from a menu screen displayed as a stereoscopic image, by the display unit 23, and set the scan mode ON using a hand gesture. An image of the hand gesture is captured and detected by the imaging unit 21, and the computer in the smart glasses 10 recognizes that the scan mode has been selected, based on the detection result. Alternatively, the worker may turn on the scan mode by pressing a predetermined button provided to the smart glasses 10.

When the scan mode is turned on, the smart glasses 10 scan the space inside the clean room 40 including the substrate processing apparatus 50, using the depth sensor, and create a spatial mesh. The display unit 23 displays the mesh graphic in a manner superimposed over the space in the field of view of the worker, perceived through the visor 11.

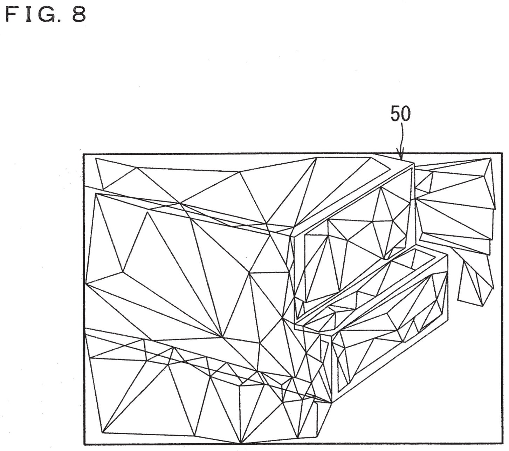

FIG. 8 is a diagram illustrating an example of the spatial mesh. As illustrated in this diagram, the spatial mesh created by the smart glasses 10 is represented by a number of triangular meshes. Various shapes including a curved surface and a flat surface are represented by a set of a large number of connected triangles. A complex shape including a concave and a convex is represented by high-density triangles; by contrast, a flat shape is represented by relatively low-density triangles. A spatial mesh created by scanning a space including the substrate processing apparatus 50 with the smart glasses 10 is displayed in a manner superimposed over the actual substrate processing apparatus 50.

Even in a case where a plurality of substrate processing apparatuses 50 of the same type and the same format (that is, those having the same appearance) are arranged in the clean room 40, by creating a spatial mesh by scanning a space including the plurality of substrate processing apparatuses 50, the created spatial meshes exhibit differences due to the subtle differences in the environment surrounding the substrate processing apparatuses 50 (for example, a difference in the setting of an aisle). Therefore, with the differences in the spatial meshes, the smart glasses 10 can identify the plurality of substrate processing apparatuses 50 arranged in the clean room 40.

The worker scans the space including the substrate processing apparatus 50 with the smart glasses 10, creates a spatial mesh, and then installs a virtual object on the spatial mesh being displayed. The virtual object is a virtual marker displayed as a stereoscopic image by the display unit 23. The worker places a virtual object at an arbitrary position near the substrate processing apparatus 50, using a hand gesture (e.g., by pinching the object with fingers), in an image displaying the spatial mesh, such as that illustrated in FIG. 8. The worker may then make a fine adjustment of the position of the virtual object using a remote-controller screen being displayed as a stereoscopic image by the display unit 23. The virtual object may be installed at a position overlapping with the substrate processing apparatus 50.

When the virtual object is installed in the spatial mesh of the substrate processing apparatus 50, the smart glasses 10 establish the position of the virtual object as a reference position with respect to the substrate processing apparatus 50. Furthermore, by installing the virtual object in the spatial mesh, the smart glasses 10 recognize the position of the virtual object itself using the characterizing portion of the spatial mesh. The characterizing portion of the spatial mesh is, for example, a portion exhibiting a characterizing form of mesh at the time of scanning, such as a corner of the substrate processing apparatus 50.

The positions of the regions in the substrate processing apparatus 50 are calculated and registered, based on the reference position set by installing the virtual object. For example, the worker superimposes a CAD drawing representing the substrate processing apparatus 50 over the area of the substrate processing apparatus 50 perceivable through the visor 11. At this time, it is preferable to superimpose a 3D CAD drawing over the substrate processing apparatus 50. The CAD drawing of the substrate processing apparatus 50 is created in advance at the stage of apparatus designing, and the data of the CAD drawing is stored in the storage unit 74 in the server 70, for example. The smart glasses 10 read the data of the CAD drawing of the substrate processing apparatus 50 from the server 70, and cause the display unit 23 to display the CAD drawing. The worker then superimposes the CAD drawing over the substrate processing apparatus 50, by moving the CAD drawing being displayed, using a hand gesture. At this time, the worker may make a fine adjustment of the position of the CAD drawing, using a remote-controller screen being displayed as a stereoscopic image by the display unit 23.

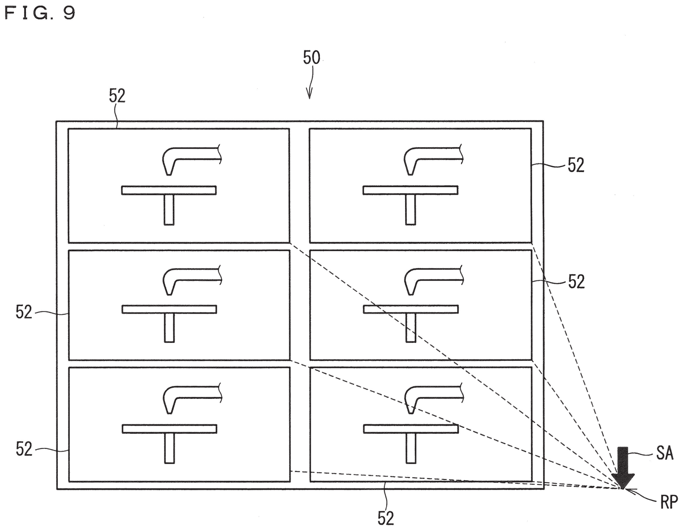

By superimposing the CAD drawing of the substrate processing apparatus 50 over the area of the substrate processing apparatus 50 perceivable through the visor 11, precisely, the smart glasses 10 are caused to calculate and register the relative positional relationship between the reference position (the position of the virtual object) and the regions included in the substrate processing apparatus 50. FIG. 9 is a diagram schematically illustrating relative positional relationships between a reference position and regions in the substrate processing apparatus 50. When a virtual object SA is installed, the position is registered as a reference position RP. The position of the region included in the substrate processing apparatus 50 can be obtained from the coordinate information included in the CAD data. The smart glasses 10 calculate and register a relative positional relationship between the reference position RP and a region in the substrate processing apparatus 50 (e.g., a corner of the substrate processing apparatus 50), based on the position information of the reference position RP and the coordinate information in the data of the CAD drawing superimposed over the substrate processing apparatus 50.

The data of the CAD drawing also includes coordinate information of the processing units 52 provided to the substrate processing apparatus 50, and regions (e.g., the spin chuck 62 and the treatment liquid nozzle 65) provided to the respective processing units 52. Therefore, the smart glasses 10 calculate and register a relative positional relationship between each of the plurality of processing units 52 mounted on the substrate processing apparatus 50 and the reference position RP. The smart glasses 10 also calculate and register a relative positional relationship between a region provided to each of the processing units 52 and the reference position RP. Regarding the driving region such as the treatment liquid nozzle 65, because the coordinate information included in the data of the CAD drawing represents the home position, calculated herein is a relative positional relationship between the driving region at the home position (the standby position mentioned above, in the case of the treatment liquid nozzle 65) and the reference position RP.

The smart glasses 10 may register the calculated relative positional relationship between the reference position RP and a region in the substrate processing apparatus 50 by writing the relative positional relationship in a position table, for example. Specifically, the smart glasses 10 register the name of the virtual object, the apparatus region in the substrate processing apparatus 50 associated therewith, the relative position information of the apparatus region, and the like, in a manner associated with one another, in the position table.

The smart glasses 10 do not need to calculate and register the relative positional relationship for all of the regions included in the substrate processing apparatus 50, and may calculate the relative positional relationships for the necessary regions. The regions included in the substrate processing apparatus 50 include a representative point of the entire substrate processing apparatus 50, the plurality of processing units 52 mounted on the substrate processing apparatus 50, and various mechanisms provided to each of the processing units 52. For example, the smart glasses 10 may calculate and register a relative positional relationship of only the treatment liquid nozzle 65 of the substrate processing apparatus 50 with respect to the reference position RP. In other words, the smart glasses 10 may calculate and register a relative positional relationship between at least one region included in the substrate processing apparatus 50 and the reference position RP.

As a preliminary preparation process that is different from the position registration, danger levels are defined (step S12). Specifically, created herein is, for example, a danger table in which each of a plurality of danger levels is associated with a possible operation and an apparatus condition. This work may be performed by the worker using the smart glasses 10, or may be performed by the work assisting staff using the work assistance terminal 80.

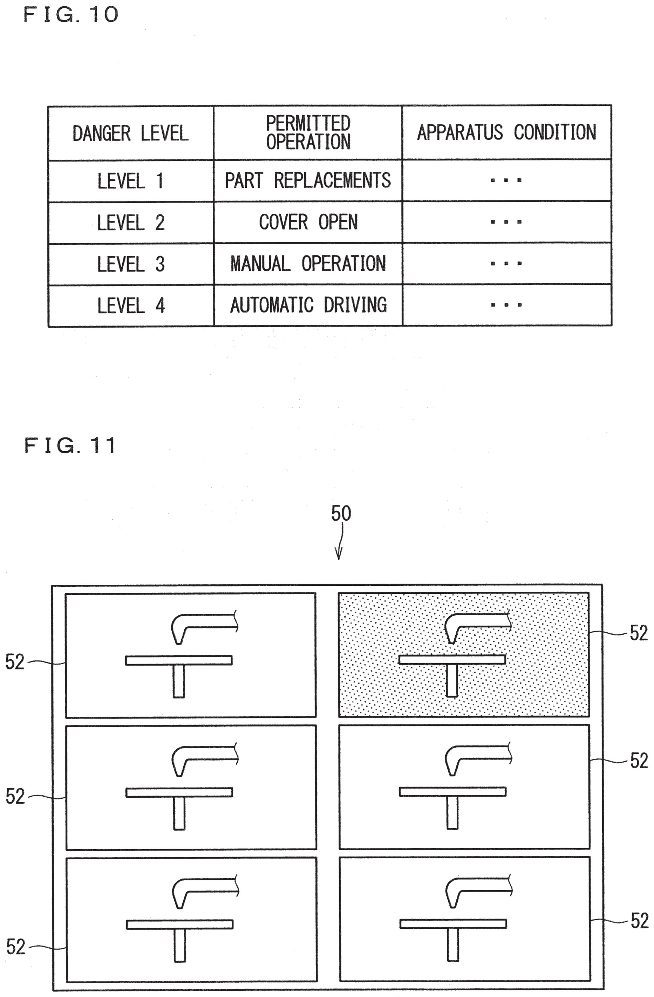

FIG. 10 is a diagram illustrating an example of the danger table. In the first embodiment, four danger levels are set, as an example. Level 1 corresponds to the lowest danger, and level 4 corresponds to the highest danger. When the danger level is level 1, the outer cover 95 and the inner cover 92 of the processing unit 52 are permitted to be opened, and parts in the treatment chamber 60 can be replaced. For this reason, in level 1 of the danger level, "PART REPLACEMENTS" and an apparatus condition corresponding to level 1 (e.g., a concentration of the chemical liquid vapor in the treatment chamber 60) are registered in a manner associated with each other. When the danger level is level 2, the outer cover 95 and the inner cover 92 are permitted to be opened. When the danger level is level 3, although the inner cover 92 is prohibited from being opened, the outer cover 95 can be opened, and manual operation can be performed on each mechanism in the processing unit 52. At the most dangerous level 4, neither the inner cover 92 nor the outer cover 95 are prohibited from being opened, and only the automatic driving of each mechanism of the processing unit 52 is permitted. Therefore, "COVER OPEN", "MANUAL OPERATION", and "AUTOMATIC DRIVING" are associated with danger level 2, level 3, and level 4, respectively, and the apparatus conditions corresponding to the respective levels are registered in a manner associated therewith, respectively.

Step S13 and subsequent steps in FIG. 7 are post-processing at the time when a worker performs maintenance work on any of the substrate processing apparatuses 50. Maintenance is performed on the substrate processing apparatus 50 regularly or irregularly. Typically, the time when an irregular maintenance is performed is when a trouble occurs in the substrate processing apparatus 50. In the embodiment, a worker performs the maintenance work while wearing the smart glasses 10.

To begin with, condition information of the apparatus condition of the substrate processing apparatus 50 is collected (step S13). Specifically, the substrate processing apparatus 50 is provided with a large number of sensors, and the control unit 55 collects condition information from each of such sensors. For example, the control unit 55 acquires the oxygen concentration and the concentration of the chemical liquid vapor (e.g., the concentration of hydrogen fluoride) in the treatment chamber 60, from a concentration meter. The control unit 55 acquires the chemical liquid concentration of the residual treatment liquid inside the treatment liquid nozzle 65, from a concentration meter that is different from the concentration meter. The control unit 55 also acquires information regarding opening and closing of each valve, for example, information indicating that the pure water valve 152 remains closed, after the chemical liquid valve 154 is opened. The condition information collected by the control unit 55 is accumulated in, for example, a storage unit included in the control unit 55. The control unit 55 may also collect information from the history of motion or the history of work (work log), in addition to the information from the sensors.

Next, based on the condition information collected in step S13, the determination unit 31 in the smart glasses 10 determines the danger level of each of the regions in the substrate processing apparatus 50 (step S14). Target regions for which determinations are to be made in step S14 include any of the spaces inside the treatment chamber 60. For example, the determination unit 31 determines a danger level corresponding to the concentration of the chemical liquid vapor in the treatment chamber 60, the danger level being identified from the danger table in FIG. 10, as the danger level inside the treatment chamber 60. When the pure water valve 152 remains closed after the chemical liquid valve 154 is opened, the determination unit 31 determines that the treatment liquid nozzle 65 is dangerous (e.g., that the danger level is level 4) because there is still high-concentration residual chemical liquid inside the treatment liquid nozzle 65.

Next, when the worker wearing the smart glasses 10 approaches the substrate processing apparatus 50 for the maintenance work, for example, the display unit 23 displays an annotation (displays an annotation) on the region determined to be dangerous, in the substrate processing apparatus 50 (the region having a danger level of level 1 or higher) (step S15). In the first embodiment, the display unit 23 of the smart glasses 10 displays a color in a manner superimposed over the space including the region in danger. In other words, the display unit 23 displays the space including the region determined to be dangerous by the determination unit 31, three-dimensionally, in a colored state.

More specifically, the smart glasses 10 identify the position of the region determined to be dangerous by the determination unit 31, based on the region position information registered in step S11. The display unit 23 of the smart glasses 10 then displays a color in a manner superimposed over the space including the identified position.

FIG. 11 is a diagram illustrating an example of display of an annotation. In the example of FIG. 11, the processing unit 52 in the upper right corner of the drawing has a high concentration of the chemical liquid vapor inside the treatment chamber 60, and the determination unit 31 determines that the space inside the treatment chamber 60 is dangerous. The display unit 23 then three-dimensionally displays the space inside the treatment chamber 60 on the upper right corner of the drawing in a colored state, as illustrated in FIG. 11.

When it is determined that a part of the region provided to the treatment chamber 60 is dangerous, the display unit 23 displays a color on a limited space only including the region. For example, when it is determined that the treatment liquid nozzle 65 containing a high-concentration residual chemical liquid is dangerous, the display unit 23 displays the space surrounding the treatment liquid nozzle 65 in a colored state. When it is determined that the pipe (the pipe 113 or the pipe 155) holding a high-pressure residual fluid is dangerous, the display unit 23 displays a color in a manner superimposed over the space surrounding the pipe.

In addition, in the first embodiment, a plurality of danger levels are defined, and the danger level is determined even for each of the regions of the processing unit 52. The display unit 23 displays a color on the space including the region determined to be dangerous, using a display color corresponding to the danger level to which the region corresponds. In other words, the display unit 23 displays a color that is different for each of the danger levels. For example, a space including a region determined to correspond to the most dangerous level 4 is displayed in red. By contrast, a space including a region determined to correspond to level 1, being a relatively low danger level, is displayed in yellow, for example. The space including a region determined to correspond to level 2 (or level 3) between such levels is displayed in orange, for example.

As described above, because the smart glasses 10 three-dimensionally display a color on a space including a region determined to be dangerous, the worker wearing the smart glasses 10 can recognize which region in the substrate processing apparatus 50 is dangerous, easily and reliably. In the first embodiment, a color is displayed in a manner superimposed over the space including the region determined to be dangerous; however, if such a region is opaque, the region ends up appearing to be displayed in a colored state, to the worker's eyes.

Furthermore, because a display color corresponding to the danger level of the region determined to be dangerous is displayed on such a region, the worker wearing the smart glasses 10 can also recognize the dangerous level of such a region.

A worker having recognized that there is a dangerous region in the substrate processing apparatus 50 may take some measure. For example, when a high-concentration chemical liquid is attached on the treatment chamber 60, the treatment liquid nozzle 65 is caused to discharge pure water to wash away the chemical liquid. When there is high-pressure residual fluid inside the pipe, a release valve, not illustrated, is opened to reduce the pressure.

The operation permitted to be performed by a worker as the measure is determined by the danger level of the region (that is, by the display color). Specifics thereof are defined in the danger table. For example, when the space inside the treatment chamber 60 is displayed in the yellow color, the worker is permitted to open both of the outer cover 95 and the inner cover 92; but when the space is colored in orange, the worker is only permitted to open the outer cover 95. When the space inside the treatment chamber 60 is in the red color, the worker is permitted to open neither the outer cover 95 nor the inner cover 92.

When the condition information is acquired and the danger level is determined again after such a measure is taken, a lower danger level may be determined for the region having been determined to be dangerous (step S16). When the danger level of the target region changes as a result of the measure, the process proceeds from step S16 to step S17, and the display unit 23 changes the display color in accordance with the danger level after the change. For example, when the high-concentration chemical liquid attached to the inside of the treatment chamber 60 is washed away, and the danger level of the space inside the treatment chamber 60 drops from level 4 to level 1, the display unit 23 changes the display color of the space inside the treatment chamber 60 from red to yellow. As a result, the worker can recognize that the danger level inside the treatment chamber 60 has dropped.

Although high-concentration chemical liquid vapor in the treatment chamber 60 or high-pressure residual fluid in the pipe is a dangerous condition, such a condition is usually not directly visible to human eyes. Therefore, the worker cannot recognize the dangerous condition, and an accident may occur. In the first embodiment, determination of danger is made based on the collected condition information, and the smart glasses 10 display a color in a manner superimposed over a space including the target region determined to be dangerous. In other words, the smart glasses 10 visualize the danger not directly perceivable with human eyes by coloring. With this, it can be recognized, at a glance, where in the substrate processing apparatus 50 is dangerous, and the worker can get a grasp of the dangerous part at a glance. As a result, the worker can recognize invisible dangerous conditions easily and reliably, so that a proactive accident prevention can be performed.

In the first embodiment, a color is displayed on the space including the target region, using a display color corresponding to the danger level to which the target region corresponds. As a result, the worker can easily recognize the danger level of the target region. Because permitted operations are determined in accordance with the danger level, it is possible to cope with a danger flexibly, in accordance with the danger level, as compared with a configuration in which the operations are entirely prohibited uniformly, in the presence of danger.

Furthermore, in the first embodiment, when the danger level to which the target region corresponds changes, as a result of an operation on the target region, the display color is changed in accordance with the danger level after the change. As a result, the worker can easily recognize the effect of the measure taken.

### <Second Embodiment>

A second embodiment of the present invention will now be described. A work assistance system according to the second embodiment has the same configuration as that in the first embodiment. In the first embodiment, when the worker wearing the smart glasses 10 approaches the substrate processing apparatus 50 even without much thought, a dangerous region is displayed in a colored state. However, in the second embodiment, when the worker attempts to perform predetermined work on the substrate processing apparatus 50, the region involved in the work is displayed in a colored state, to indicate whether such a region is dangerous or not.

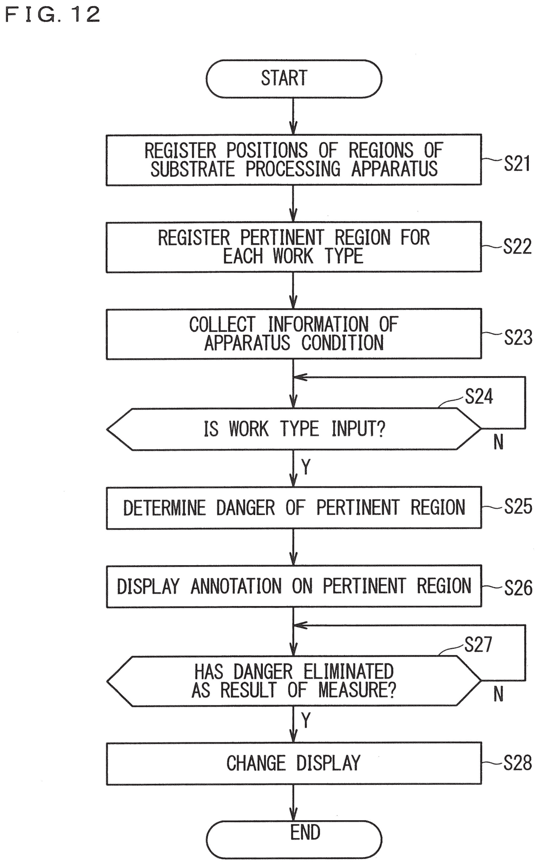

FIG. 12 is a flowchart illustrating the sequence of a work assistance method according to the second embodiment. Of the steps illustrated in FIG. 12, steps S21 and S22 are steps of preliminary preparations.

The step of position registration in step S21 is the same as that in step S11 according to the first embodiment. In other words, a relative positional relationship between a region included in the substrate processing apparatus 50 and the reference position RP is calculated and registered using the VPS function provided to the smart glasses 10, in the same manner as in the first embodiment.

In the second embodiment, a pertinent region with a chance of occurrence of a danger is registered in a manner associated with each type of work on the substrate processing apparatus 50 (step S22). Specifically, a work table in which each type of work for the substrate processing apparatus 50 is associated with a pertinent region is created.

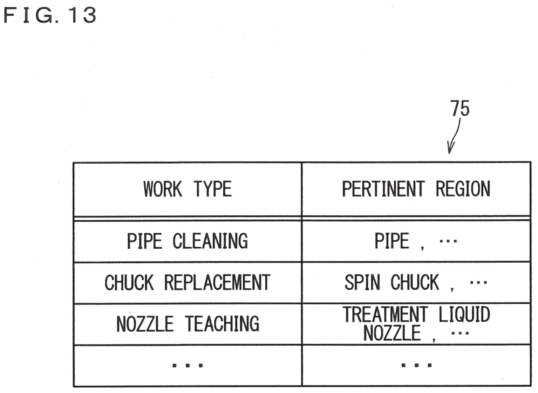

FIG. 13 is a diagram illustrating an example of the work table 75 in which a pertinent region with a chance of occurrence of a danger is registered in association with each type of work. As types of work for the substrate processing apparatus 50, for example, "PIPE CLEANING", "CHUCK REPLACEMENT", "NOZZLE TEACHING", and the like are set. In the work table 75, a pertinent region with a chance of occurrence of a danger is registered in a manner associated with each type of work. For example, for the work type "CHUCK REPLACEMENT", a spin chuck is registered as a pertinent region with a chance of occurrence of a danger. The work table 75, such as that illustrated in FIG. 13, may be created by the worker by using the smart glasses 10, or may be created by work assisting staff using the work assistance terminal 80. The work table 75 thus created is stored in the storage unit 74 of the server 70 (FIG. 6), for example.

Condition information related to the apparatus condition of the substrate processing apparatus 50 is then collected (step S23). This process is the same as the process of step S13 in the first embodiment. In other words, the control unit 55 of the substrate processing apparatus 50 collects the condition information from the sensors and the work history.

A worker who intends to perform a predetermined work on the substrate processing apparatus 50 then inputs the type of the work, using the smart glasses 10 (step S24). As a specific input method, for example, the worker causes the display unit 23 of the smart glasses 10 to display a virtual keyboard as a stereoscopic image, and enters the type of work from the keyboard, using a hand gesture. Alternatively, the worker may cause the display unit 23 of the smart glasses 10 to display the work type registered in the work table 75 as a list, and select a work type from the list. The smart glasses 10 may also be provided with a microphone, and the worker may enter the work type via voice input.

When the work type is entered with the smart glasses 10, the process proceeds from step S24 to step S25, and the determination unit 31 in the smart glasses 10 determines whether the pertinent region associated with the entered work type is dangerous. Specifically, the determination unit 31 extracts the pertinent region associated with the entered work type, from the work table 75. For example, when "CHUCK REPLACEMENT" is entered as the work type from the smart glasses 10, the determination unit 31 extracts the spin chuck, the spin motor, and the like that are associated with "CHUCK REPLACEMENT" in the work table 75. The determination unit 31 then determines whether the extracted pertinent region is dangerous, based on the condition information collected in step S23 (step S25). In the above example, the determination unit 31 determines whether the spin chuck 62 and the spin motor 63 are dangerous based on the collected condition information. In the second embodiment, it is not necessarily needed to determine the danger level.

The display unit 23 of the smart glasses 10 displays an annotation on the pertinent region (step S26). In the second embodiment, the display unit 23 displays a first display color on the space including the pertinent region determined to be dangerous, and displays a second display color on the space including the pertinent region determined not to be dangerous. In the above example, for example, the display unit 23 colors the space including the spin chuck 62, which is the pertinent region determined to be dangerous, in red, and colors the space including the spin motor 63, which is the pertinent region determined not to be dangerous, in green.

The smart glasses 10 identify the position of the extracted pertinent region, based on the region position information registered in step S21, in the same manner as in the first embodiment. The display unit 23 of the smart glasses 10 then displays the first display color (red in the above example) representative of being dangerous or a second display color (green in the above example) representative of being safe, on the space including the identified position.

With the use of such a display mode, the worker wearing the smart glasses 10 can easily recognize whether the region pertinent to the work to be done is dangerous. Work on a pertinent region with the first display color is prohibited, and work on a pertinent region with the second display color is permitted.

The worker may take some measure on the pertinent region with the first display color. The operation performed on the pertinent region as a measure is the same as that in the first embodiment. When the condition information is acquired and the danger level is determined again after such a measure is taken, the danger in the pertinent region may have been eliminated (step S27). If the pertinent region becomes no longer dangerous as a result of the measure, the process proceeds from step S27 to step S28, and the color displayed on the space including the pertinent region is changed. Specifically, the display unit 23 changes the color displayed on the space including the pertinent region from the first display color to the second display color. As a result, the worker can recognize that the danger in the pertinent region has been eliminated, and can now work on the pertinent region.

In the second embodiment, determination of danger is made based on the collected condition information, and the smart glasses 10 display a color in a manner superimposed over a space including a pertinent region determined to be dangerous. In other words, the smart glasses 10 visualize the danger not directly perceivable with human eyes by coloring. Therefore, as in the first embodiment, the worker can reliably recognize a dangerous condition that is invisible.

Furthermore, in the second embodiment, the presence or absence of danger in a region related to the work that the worker intends to perform is displayed in a manner color-coded. As a result, the worker can easily recognize whether the worker can work on the pertinent region.

Furthermore, in the second embodiment, when the pertinent region determined to be dangerous becomes no longer dangerous due to an operation performed on the pertinent region, the color displayed on the space including the pertinent region is changed from the first display color to the second display color. As a result, the worker can easily recognize the effect of the measure taken.

### <Modifications>

Although the embodiments of the present invention have been described above, various modifications other than those described above may be made within the scope not departing from the gist of the present invention. For example, in each of the embodiments described above, the smart glasses 10 display an annotation by coloring of the space, but the present invention is not limited thereto, and any presentation capable of drawing the attention of workers may be used. For example, as a presentation of an annotation, the smart glasses 10 may present a warning message, or may issue a warning using voice. Furthermore, the smart glasses 10 may display a numerical value indicating a danger level.

In addition to the coloring, the smart glasses 10 may display a text for the steps of operations for eliminating the danger of the target region.

In the first embodiment, a color is displayed in a manner superimposed over the space including a region determined to be dangerous, but in addition to this configuration, it is also possible to display a display color (e.g., blue) different from such a color, on the space including a safe region.

In each of the above embodiments, the determination unit 31 in the smart glasses 10 makes the determination of danger, but the present invention is not limited thereto, and the work assistance terminal 80 or the server 70 may make the determination of danger. Alternatively, the control unit 55 of the substrate processing apparatus 50 may make the danger determination in the substrate processing apparatus 50.

Furthermore, it is also possible for the display unit 23 in the smart glasses 10 to display a pull-down from which "normal", "maintenance", and "work" can be selected, as a stereoscopic image, for example. When "normal" is selected, the smart glasses 10 do not display the annotation. The smart glasses 10 may be prevented from displaying an annotation even when there is no need. The smart glasses 10 may be shifted to a mode for displaying an annotation as in the first embodiment, when "maintenance" is selected, and shifted to a mode for executing as in the second embodiment when "work" is selected.

In each of the embodiments described above, the worker uses the smart glasses 10, but the present invention is not limited thereto, and a mobile terminal such as a tablet terminal or a smartphone may be used instead of the smart glasses 10. In other words, any mobile terminal including a display unit and a communication unit may be used. However, when a tablet terminal or the like is used, a hand of a worker holding the tablet terminal becomes unavailable, so that it is preferable to use a wearable terminal such as the smart glasses 10.

Furthermore, the substrate processing apparatus 50 is not limited to the substrate cleaning apparatus, and may be any apparatus that performs a predetermined process on a substrate, such as a thermal treatment apparatus, an exposure apparatus, a coating and development apparatus, a measurement apparatus, or an inspection apparatus. When the substrate processing apparatus 50 is a substrate cleaning apparatus, it may be a single-wafer cleaning apparatus that cleans substrates one by one, or may be a batch cleaning apparatus that cleans a plurality of substrates as a batch. Nevertheless, the work assistance technology according to the present invention is suitable for a liquid treatment apparatus such as a substrate cleaning apparatus where there may be an invisible dangerous condition due to the use of a chemical liquid. Described in the embodiment above is an example in which the gas feeder unit 110 feeds nitrogen gas as the treatment gas for forming a down flow in the treatment chamber 60 and achieving a low-oxygen atmosphere, but it is also possible for a shielding plate or another gas nozzle to feed a treatment gas different from the nitrogen gas so as to create a specific atmosphere involved in the treatment, around the substrate W. Examples of such a treatment gas include oxygen (O₂), ozone (O₃), and ammonia (NH₃).

Furthermore, the target of the work assistance technology according to the present invention is not limited to the substrate processing apparatus, and may be any industrial equipment where some invisible dangerous condition may arise. Examples of such industrial equipment include a printing processing apparatus, a deposition apparatus, a medical apparatus, and an appearance inspection apparatus.

### EXPLANATION OF REFERENCE SIGNS

5: information communication network
10: smart glasses
21: imaging unit
22: communication unit
23: display unit
24, 74: storage unit
31: determination unit
50: substrate processing apparatus
52: processing unit
61: rotation holder
62: spin chuck
65: treatment liquid nozzle
66: nozzle tip
70: server
75: work table
80: work assistance terminal
92: inner cover
95: outer cover
110: gas feeder unit
120: exhaust unit
130: drainage unit
150: treatment liquid feeder unit
W: substrate

## Claims

1. A work assistance method for predetermined work to be carried out on industrial equipment, the work assistance method comprising:
an information acquisition step of collecting condition information related to an apparatus condition of the industrial equipment;
a determination step of determining whether a target region of the industrial equipment is dangerous based on the condition information;
and a display step of causing a mobile terminal including a display unit and a communication unit to display an annotation on the target region determined to be dangerous in the determination step.

2. The work assistance method according to claim 1, wherein, in the display step, the mobile terminal is caused to display a color in a manner superimposed over a space including the target region.

3. The work assistance method according to claim 2, wherein
the determination step includes determining which of a plurality of danger levels the target region corresponds to, and
the display step includes displaying a display color corresponding to a danger level to which the target region corresponds, on the space including the target region.

4. The work assistance method according to claim 3, wherein, when the danger level of the target region changes, as a result of an operation performed on the target region, the display color is changed in accordance with a danger level after change.

5. The work assistance method according to claim 1, further comprising
a registration step of registering a pertinent region with a chance of occurrence of a danger, in association with each type of work to be performed on the industrial equipment, wherein
the determination step includes determining, when a work type is input from the mobile terminal, whether the pertinent region registered in association with the work type is dangerous, and
the display step includes displaying an annotation on the pertinent region determined to be dangerous.

6. The work assistance method according to claim 5, wherein the display step includes displaying a first display color on the space including the pertinent region determined to be dangerous, and displaying a second display color on the space including the pertinent region determined not to be dangerous.

7. The work assistance method according to claim 6, wherein, when the pertinent region determined to be dangerous becomes no longer dangerous, as a result of an operation performed on the pertinent region, the color displayed on the space including the pertinent region is changed from the first display color to the second display color.

8. The work assistance method according to any one of claims 1 to 7, wherein the industrial equipment is a substrate processing apparatus that performs a predetermined process on a substrate.

9. The work assistance method according to claim 8, wherein the substrate processing apparatus is a substrate cleaning apparatus that uses a treatment gas and a treatment liquid.

10. The work assistance method according to any one of claims 1 to 7, wherein the mobile terminal is a pair of smart glasses.

11. A work assistance system for predetermined work to be carried out on industrial equipment, the work assistance system comprising:
a mobile terminal including a display unit and a communication unit; and
a determination unit that determines whether a target region in the industrial equipment is dangerous based on condition information related to an apparatus condition of the industrial equipment, wherein
the display unit displays an annotation on the target region determined to be dangerous by the determination unit.

12. The work assistance system according to claim 11, wherein the display unit displays a color in a manner superimposed over a space including the target region.

13. The work assistance system according to claim 12, wherein
the determination unit determines which of a plurality of danger levels the target region corresponds to, and
the display unit displays a display color corresponding to the danger level to which the target region corresponds, on the space including the target region.

14. The work assistance system according to claim 13, wherein, when the danger level of the target region changes as a result of an operation performed on the target region, the display unit changes the display color in accordance with the danger level after change.

15. The work assistance system according to claim 11, further comprising a storage unit that stores a table in which a pertinent region with a chance of occurrence of a danger is registered, in association with each type of work on the industrial equipment, wherein
when a work type is input from the mobile terminal, the determination unit determines whether the pertinent region registered in association with the work type is dangerous, and
the display unit displays an annotation on the pertinent region determined to be dangerous.

16. The work assistance system according to claim 15, wherein the display unit displays a first display color on a space including the pertinent region determined to be dangerous, and displays a second display color on a space including the pertinent region determined not to be dangerous.

17. The work assistance system according to claim 16, wherein, when the pertinent region becomes no longer dangerous as a result of an operation performed on the pertinent region determined to be dangerous, the display unit changes the color of the space including the pertinent region from the first display color to the second display color.

18. The work assistance system according to any one of claims 11 to 17, wherein the industrial equipment is a substrate processing apparatus that performs a predetermined process on a substrate.

19. The work assistance system according to claim 18, wherein the substrate processing apparatus is a substrate cleaning apparatus that uses a treatment gas and a treatment liquid.

20. The work assistance system according to any one of claims 11 to 17, wherein the mobile terminal is a pair of smart glasses.
